(19) Europäisches Patentamt
European Patent Office
Office européen des brevets

(11) **EP 4 376 250 B1**

(12) **EUROPEAN PATENT SPECIFICATION**

(45) Date of publication and mention
of the grant of the patent:
**04.03.2026   Bulletin 2026/10**

(21) Application number: **22845379.1**

(22) Date of filing: **21.07.2022**

(51) International Patent Classification (IPC):
*H02J 7/00* (2026.01)    *H01M 10/44* (2006.01)
*G01R 31/382* (2019.01)    *G01R 31/388* (2019.01)
*H01M 10/48* (2006.01)

(52) Cooperative Patent Classification (CPC):
**H01M 10/441; G01R 31/382; G01R 31/388;
H01M 10/443; H01M 10/482; H01M 10/486;
H02J 7/50; H02J 7/94; H02J 7/96; H02J 7/977;
Y02E 60/10**

(86) International application number:
**PCT/CN2022/106937**

(87) International publication number:
**WO 2023/001214 (26.01.2023 Gazette 2023/04)**

(54) **MULTI-BATTERY-PACK CHARGING MANAGEMENT METHOD AND APPARATUS, AND ENERGY STORAGE DEVICE**

VERFAHREN UND VORRICHTUNG ZUR VERWALTUNG DES LADENS MEHRERER BATTERIEPACKS UND ENERGIESPEICHERVORRICHTUNG

PROCÉDÉ ET APPAREIL DE GESTION DE CHARGE DE BLOCS-BATTERIES MULTIPLES, ET DISPOSITIF DE STOCKAGE D'ÉNERGIE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority:  **22.07.2021   CN 202110833046**

(43) Date of publication of application:
**29.05.2024   Bulletin 2024/22**

(73) Proprietor: **EcoFlow Inc.**
**Shenzhen, Guangdong 518000 (CN)**

(72) Inventors:
• **WANG, Lei**
**Shenzhen, Guangdong 518000 (CN)**
• **XING, Yunhui**
**Shenzhen, Guangdong 518000 (CN)**

(74) Representative: **Appelt, Christian W.**
**Boehmert & Boehmert
Anwaltspartnerschaft mbB
Pettenkoferstrasse 22
80336 München (DE)**

(56) References cited:
CN-A- 103 051 027    CN-A- 112 104 015
CN-A- 112 994 156    CN-A- 113 098 099
CN-A- 113 131 550    CN-A- 113 131 550
CN-A- 113 437 778

**Description**

**TECHNICAL FIELD**

The present application relates to a charging management method and apparatus for multiple battery packs, and an energy storage device.

**BACKGROUND**

The description here merely provides background information related to the present application and does not necessarily constitute the prior art.

When multiple battery packs are charged by a charging device, the battery packs do not interact with the charging device, and the charging device merely outputs a constant charging voltage and a constant charging current. At this time, if the charging current and the charging voltage are too large, the battery pack may explode due to over-current or over-voltage, causing electric accidents. However, if the charging current and the charging voltage are too small, the maximum performance of the charging device cannot be fully used, resulting in a slow charging speed and long charging time.

CN 113131550 A describes a charging control system that includes a battery and a charging controller with an analog-to-digital converter sampling module. This system is designed to acquire sampled voltage, current, and temperature values from the battery, which are then used by the charging controller to determine the battery's float pressure and actual voltage. Based on these values, the charging controller calculates the charging current.

CN 112994156 A describes a charging control method and system for a multi-branch battery pack used in diesel engine + battery hybrid locomotives. The system includes a charging controller that calculates the remaining power available for charging based on the locomotive's operating conditions and then determines the total charging supply current. The charging controller allocates the charging current proportionally to each battery branch based on their respective maximum allowable charging currents.

**SUMMARY**

According to the present invention, a charging management method and apparatus for multiple battery packs, and an energy storage device having the features of the respective independent claims are provided.

The present invention provides a charging management method for multiple battery packs. The method includes:

acquiring sampled temperatures, sampled voltages and sampled charging currents of various battery packs;
determining a target charging current of each battery pack according to the sampled temperature of each battery pack and the sampled voltage of each battery pack;
calculating a difference between the sum of the target charging currents of the various battery packs and the sum of the sampled charging currents of the various battery packs, to obtain a total PI adjustment value;
sending the total PI adjustment value to a charging device, to enable the charging device to adjust a total charging current according to the total PI adjustment value; and
receiving the total charging current, determining a charging current of each battery pack according to the sampled charging current of each battery pack and the total charging current, and determining a charging voltage of each battery pack according to the sampled voltage of each battery pack.

The present invention further provides a charging management apparatus for multiple battery packs. The apparatus includes:

an acquisition module, configured to acquire sampled temperatures, sampled voltages and sampled charging currents of various battery packs;
a determination module, configured to determine a target charging current of each battery pack according to the sampled temperature of each battery pack and the sampled voltage of each battery pack;
a calculation module, configured to calculate a difference between the sum of the target charging currents of the various battery packs and the sum of the sampled charging currents of the various battery packs, to obtain a total PI adjustment value;
a sending module, configured to send the total PI adjustment value to a charging device, to enable the charging device to adjust a total charging current according to the total PI adjustment value; and
a charging module, configured to receive the total charging current, determine a charging current of each battery pack according to the sampled charging current of each battery pack and the total charging current, and determine a charging voltage of each battery pack according to the sampled voltage of each battery pack.

The present application provides an energy storage device, which includes a storage and a processor, where the storage stores a computer program thereon, and the computer program, when executed by the processor, implements the charging management method for multiple battery packs according to the present application.

Details of one or more embodiments according to the present application are provided in the accompanying drawings and descriptions below. Other features, objectives, and advantages of the present application will become apparent from the specification, the drawings, and the claims.

## BRIEF DESCRIPTION OF THE DRAWINGS

To describe the technical solutions in the embodiments of the present application more clearly, the drawings needed to be used in the embodiments of the present application will be described briefly below. It should be understood that the drawings merely show some embodiments of the present application, and thus should not be regarded as limitations on the scope of protection of the present application. In the drawings, similar parts are represented by similar numerals.

Fig. 1 schematically shows a flow chart of a charging management method for multiple battery packs provided in an embodiment of the present application.
Fig. 2 schematically shows a flow chart of a process for acquiring sampled temperatures of various battery packs in a charging management method for multiple battery packs provided in an embodiment of the present application.
Fig. 3 schematically shows a flow chart of a process for determining a target charging current of each battery pack in a charging management method for multiple battery packs provided in an embodiment of the present application.
Fig. 4 schematically shows a principle of PI adjustment provided in an embodiment of the present application.
Fig. 5 schematically shows a flow chart of a process for determining a charging current of each battery pack in a charging management method for multiple battery packs provided in an embodiment of the present application.
Fig. 6 schematically shows a flow chart of another process for determining a charging current of each battery pack in a charging management method for multiple battery packs provided in an embodiment of the present application.
Fig. 7 schematically shows a flow chart of a process for determining a charging voltage of each battery pack in a charging management method for multiple battery packs provided in an embodiment of the present application.
Fig. 8 shows a charging management system for multiple battery packs provided in an embodiment of the present application.
Fig. 9 schematically shows a flow chart of another charging management method for multiple battery packs provided in an embodiment of the present application.
Fig. 10 shows another charging management system for multiple battery packs provided in an embodiment of the present application.
Fig. 11 shows a schematic structural view of a charging management apparatus for multiple battery packs provided in an embodiment of the present application.

List of numerals: 10-charging management apparatus for battery packs; 11-acquisition module; 12-determination module; 13-calculation module; 14-sending module; 15-charging module.

## DETAILED DESCRIPTION

The technical solutions according to the embodiments of the present application will be described clearly and fully below with reference to the accompanying drawings in the embodiments of the present application. Apparently, the embodiments described are merely some, but not all of the embodiments of the present application.

Generally, the components of the embodiments of the present application described and illustrated in the drawings herein can be arranged and designed in various different configurations. Therefore, the following detailed description of the embodiments of the present application provided in connection with the accompanying drawings is not intended to limit the scope of the claimed application, but merely represents selected embodiments of the present application.

Hereinafter, as used in various embodiments of the present application, the terms "include", "have" and derivatives thereof are only intended to indicate specific features, values, steps, operations, elements, components, or combinations thereof, and should not be construed as excluding the presence of one or more other features, values, steps, operations, elements, components, or combinations thereof, or the possibility of adding one or more other features, values, steps, operations, elements, components, or combinations thereof.

In addition, the terms "first", "second", and "third" are only used for distinguishing description, and cannot be interpreted as indicating or implying relative importance.

Unless otherwise defined, all terms (including technical and scientific terms) used herein have the same meaning as commonly understood by one of ordinary skill in the art to which embodiments of the present application belongs. The terms (such as those defined in commonly used dictionaries) will be interpreted as having the same meaning as the contextual meaning in related art and will not be interpreted as having an idealistic meaning or an overly formal meaning, unless clearly defined in various embodiments of the present application.

The embodiment provided in the present application is suitable for use in an energy storage device including battery modules. The battery module includes several cells that are connected in series or in parallel to form a battery pack, and several battery packs are connected in series or in parallel to form the battery module. The battery module is provided with an interface through which the battery module outputs current or receives current for being charged. In other embodiments, the battery module of the energy storage device may include a single cell or a plurality of cells. Each cell can discharge or receive current for being charged independently or in combination with other cells. In other embodiments, the battery module of the energy storage device includes several cells that are connected in series or in parallel to form a battery pack. Each battery pack can discharge or receive current for being charged independently or in combination with other battery packs.

The charging management method for multiple battery packs provided in the present application is suitable for use in an energy storage device including several battery packs, and also in an energy storage device including only several cells. Hereinafter, the charging management method for multiple battery packs provided in the present application will be further explained by way of examples where multiple battery packs are charged.

According to the charging management method for multiple battery packs disclosed in the present application, when multiple battery packs are charged, if the multiple battery packs include a master battery pack, the master battery pack can be configured to acquire sampled temperatures, sampled voltages and sampled charging currents of various battery packs; determine a target charging current of each battery pack according to the sampled temperature of each battery pack and the sampled voltage of each battery pack; calculate a difference between the sum of the target charging currents of the various battery packs and the sum of the sampled charging currents of the various battery packs, to obtain a total PI adjustment value; send the total PI adjustment value to a charging device, to enable the charging device to adjust a total charging current according to the total PI adjustment value; and receive the total charging current, determine a charging current of each battery pack according to the sampled charging current of each battery pack and the total charging current, and determine a charging voltage of each battery pack according to the sampled voltage of each battery pack. In the present application, the sampled temperatures, sampled voltages and sampled charging currents of various battery packs are acquired by the master battery pack, and the output of the charging device is controlled by using the sampled temperatures, sampled voltages and sampled charging currents of the various battery packs, so that the maximum performance of the charging device is fully utilized while ensuring the electrical safety, to improve the charging efficiency and shorten the charging time.

It can be understood that when multiple battery packs are charged, if the multiple battery packs do not include a master battery pack, the multiple battery packs can be connected to an intermediate controller, and the intermediate controller is used to implement the charging management method for multiple battery packs. Sampled temperatures, sampled voltages and sampled charging currents of various battery packs are acquired by the intermediate controller, and the output of the charging device is controlled by using the sampled temperatures, sampled voltages and sampled charging currents of the various battery packs, so that the maximum performance of the charging device is fully utilized while ensuring the electrical safety, to improve the charging efficiency and shorten the charging time.

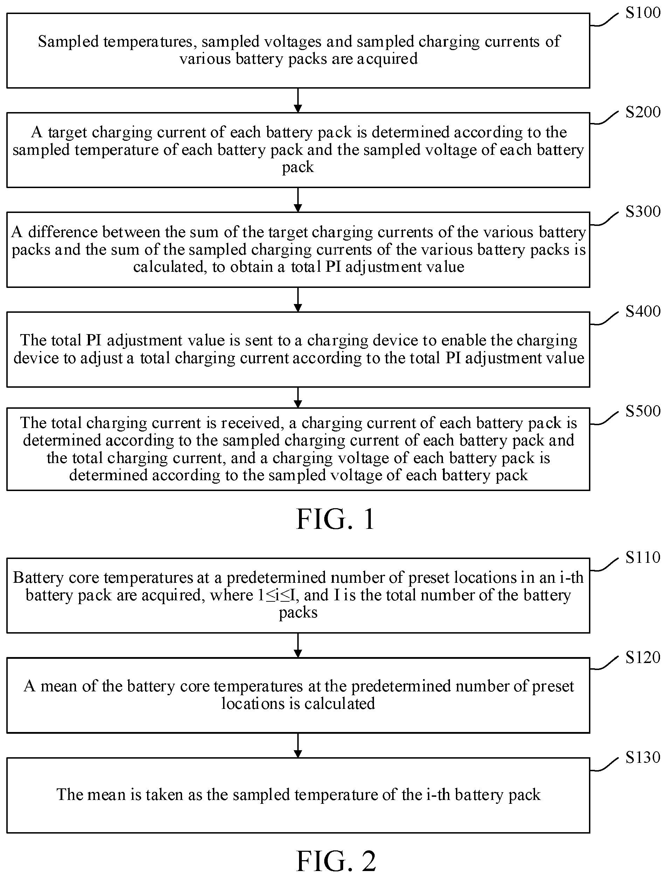

In an embodiment of the present invention, as shown in Fig. 1, a charging management method for multiple battery packs is provided, which includes Steps S100, S200, S300, S400 and S500.

S100: Sampled temperatures, sampled voltages and sampled charging currents of various battery packs are acquired.

In the charging and discharging process of a battery pack, heat accumulation will occur in the battery pack, causing the temperature rise of the battery pack. Only a short time is spent from the temperature rise to flame of the battery pack due to thermal runaway, and fire tends to occur, causing personnel injuries and property losses. If the battery pack is constantly charged with a large charging current or a high charging voltage, the battery pack will be retained in a high-temperature state for a long time, which is likely to cause flame of the battery pack.

To overcome the above problems, a voltage determination element can be used to acquire the battery pack voltage, and a temperature sensor is used to acquire a current battery pack temperature. A current target charging current of the battery pack is determined by using the battery pack temperature and the battery pack voltage, to avoid a too large charging current of the battery pack, effectively reduce flame of the battery pack, and ensure the electrical safety.

Exemplarily, each battery pack at least includes a temperature sensor, a voltage sensor and a current sensor. The temperature sensor is configured to collect the battery core temperature of the battery pack in the charging process in real time (the battery core temperature collected in real time is recorded as the sampled temperature in the present application). The voltage sensor is configured to collect the battery voltage of the battery pack in the charging process in real time (the battery voltage collected in real time is recorded as the sampled voltage in the present application). The current sensor is configured to collect the charging current of the battery pack in the charging process in real time (the charging current collected in real time is recorded as the sampled charging current in the present application).

Further, considering that there may be a deviation in the measurement of the battery core temperature at a single point, when the battery core temperature of the battery pack is determined in the present application, temperature sensors are mounted at multiple preset locations of each battery pack. Multiple battery core temperatures are acquired by the temperature sensors, and the sampled temperature of a corresponding battery pack is determined according to a mean of the battery cell temperatures at the preset multiple locations. Through multi-point measurement, the deviation in temperature acquisition is reduced, so that the sampled temperature of each battery pack is close to the actual temperature of the battery core.

Exemplarily, as shown in Fig. 2, the step of acquiring sampled temperatures of various battery packs in Step S100 includes Steps S110-S130.

S110: Battery core temperatures at a predetermined number of preset locations in an i-th battery pack are acquired, where 1≤i≤I, and I is the total number of the battery packs.

S120: A mean of the battery core temperatures at the predetermined number of preset locations is calculated.

S130: The mean is taken as the sampled temperature of the i-th battery pack.

It can be understood that when the sampled temperatures of the various battery packs are acquired, Steps S110, S120 and S130 can be performed once sequentially to determine the sampled temperature of one battery pack, and then further performed once sequentially to determine the sampled temperature of another battery pack, until the sampled temperatures of all the battery packs are determined. Alternatively, Step S110 is performed I times, then Step S120 is performed I times, and finally Step S130 is performed I times to determine the sampled temperatures of all the battery packs.

S200: A target charging current of each battery pack is determined according to the sampled temperature of each battery pack and the sampled voltage of each battery pack.

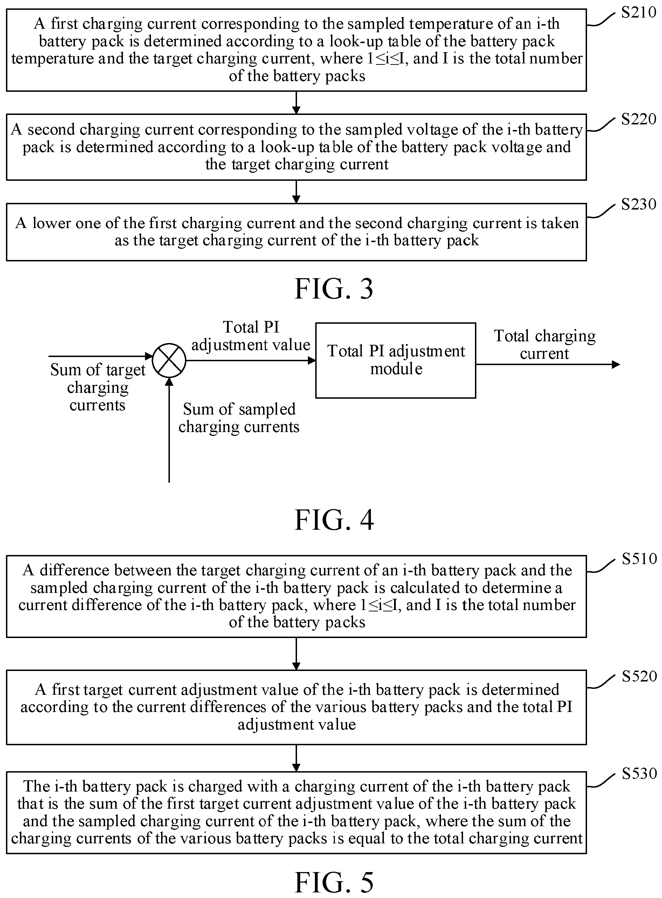

Exemplarily, as shown in Fig. 3, Step S200 may include Steps S210-S230.

S210: A first charging current corresponding to the sampled temperature of an i-th battery pack is determined according to a look-up table of the battery pack temperature and the target charging current, where 1≤i≤I, and I is the total number of the battery packs.

S220: A second charging current corresponding to the sampled voltage of the i-th battery pack is determined according to a look-up table of the battery pack voltage and the target charging current.

S230: A lower one of the first charging current and the second charging current is taken as the target charging current of the i-th battery pack.

It can be understood that when the target charging current of each battery pack is determined, Steps S210, S220 and S230 can be performed once sequentially to determine the target charging current of one battery pack, and then further performed once sequentially to determine the target charging current of another battery pack, until the target charging currents of all the battery packs are determined. Alternatively, Step S210 is performed I times, then Step S220 is performed I times, and finally Step S230 is performed I times to determine the target charging currents of all the battery packs.

It can be understood that by taking a lower one of the first charging current and the second charging current as the target charging current, and charging the battery pack with the target charging current, the fire caused by over-voltage in the charging process of the battery pack can be avoided and the fire caused by overheating in the charging process of the battery pack can also be avoided, so as to ensure electrical safety while ensuring high efficiency charging.

It can be understood that the look-up table of the battery pack temperature and the target charging current and the look-up table of the battery pack voltage and the target charging current can be the standard look-up tables in the industry, or look-up tables obtained by pre-testing the performance of different electrical products.

S300: A difference between the sum of the target charging currents of the various battery packs and the sum of the sampled charging currents of the various battery packs is calculated, to obtain a total PI adjustment value.

Exemplarily, if a battery pack A and a battery pack B are charged at the same time, the target currents of the battery pack A and the battery pack B are 10A respectively, then the total target current is 20A; and the sampled charging currents of the battery pack A and the battery pack B are respectively 9A, then the total sampled charging current is 18A. Then, the total PI adjustment value can be determined by a formula for calculating the total PI adjustment value. That is, the total PI adjustment value can be determined by a formula below:

total PI adjustment value=K* difference, in which: K is a proportional coefficient, which can be set according to the actual adjustment needs; and the difference is the difference between the total target current and the total sampled charging current. When the total target current is greater than the total sampled charging current, the difference is positive, and correspondingly the total PI adjustment value is also positive. When the total target current is less than the total sampled charging current, the difference is negative, and correspondingly the total PI adjustment value is also negative.

In this embodiment, for example, the total PI adjustment value is positive; however, in practical use, the total PI adjustment value can be negative. That is, when the charging current of each battery pack in the energy storage device is too large, the charging current of each battery pack needs to be lowered, and the total PI adjustment value at this time is negative. In other embodiments, the PI adjustment value may be 0. For example, in the energy storage device, the battery pack A has a target charging current of 10A and a sampled current of 9A, and the battery pack B has a target charging current of 10A and a sampled current of 11A, then the total target charging current is 20A, the total sampled charging current is 20A, and the total PI adjustment value at this time is 0.

As can be seen from the above, the total PI adjustment value is dynamic, and the total PI adjustment value changes with varying difference between the sum of the target charging currents of the various battery packs and the sum of the sampled charging currents of the various battery packs.

S400: The total PI adjustment value is sent to a charging device, to enable the charging device to adjust a total charging current according to the total PI adjustment value.

Exemplarily, as shown in Fig. 4, the total charging current output by the charging device can be adjusted by using a PI adjustment function of a total PI adjustment module, that is, by using the total PI adjustment value, such that the total charging current output by the charging device is close to the sum of the target charging currents of the various battery packs. It can be understood that the PI adjustment process is very fast and stable, which can effectively ensure that the total charging current output by the charging device quickly reaches the sum of the target charging currents of the various battery packs. The process during which the total charging current output by the charging device quickly reaches the sum of the target charging currents of the various battery packs is very stable, thus avoiding the interference to the charging process by the sudden change of the total charging current output by the charging device. It is to be noted that the PI adjustment in this embodiment is a broad-sense PI adjustment. For example, the total PI adjustment value can be determined by a proportional (P)- integral (I) adjuster, or the total PI adjustment value can be determined by a proportional (P) adjuster, which can be set specifically according to actual needs.

S500: The total charging current is received, a charging current of each battery pack is determined according to the sampled charging current of each battery pack and the total charging current, and a charging voltage of each battery pack is determined according to the sampled voltage of each battery pack.

Exemplarily, as shown in Fig. 5, the step of determining a charging current of each battery pack according to the sampled charging current of each battery pack and the total charging current in Step S500 includes Steps S510-S530.

S510: A difference between the target charging current of an i-th battery pack and the sampled charging current of the i-th battery pack is calculated to determine a current difference of the i-th battery pack, where $1 \leq i \leq I$, and I is the total number of the battery packs.

Step S510 is performed I times to obtain I current differences of I battery packs.

S520: A first target current adjustment value of the i-th battery pack is determined according to the current differences of the various battery packs and the total PI adjustment value.

Exemplarily, the first target current adjustment value $\Delta I_i$ of the i-th battery pack can be determined by a formula below:

$$\Delta I_i = \frac{\text{current difference of i - th battery pack}}{\text{current differences of various battery packs}} * \text{total PI adjustment value}.$$

It can be understood that the sum of the first target current adjustment values of the various battery packs is the total PI adjustment value. The larger the current difference of the battery pack is, the larger the corresponding first target current adjustment value will be. The PI adjustment of the charging current of the battery pack is carried out by using the first target current adjustment value of each battery pack, thus ensuring that when the current difference of the battery pack is larger, the sampled charging current of the battery pack can be quickly adjusted to approach the corresponding target charging current by using the larger first target current adjustment value.

S530: The i-th battery pack is charged with a charging current of the i-th battery pack that is the sum of the first target current adjustment value of the i-th battery pack and the sampled charging current of the i-th battery pack, where the sum of the charging currents of the various battery packs is equal to the total charging current.

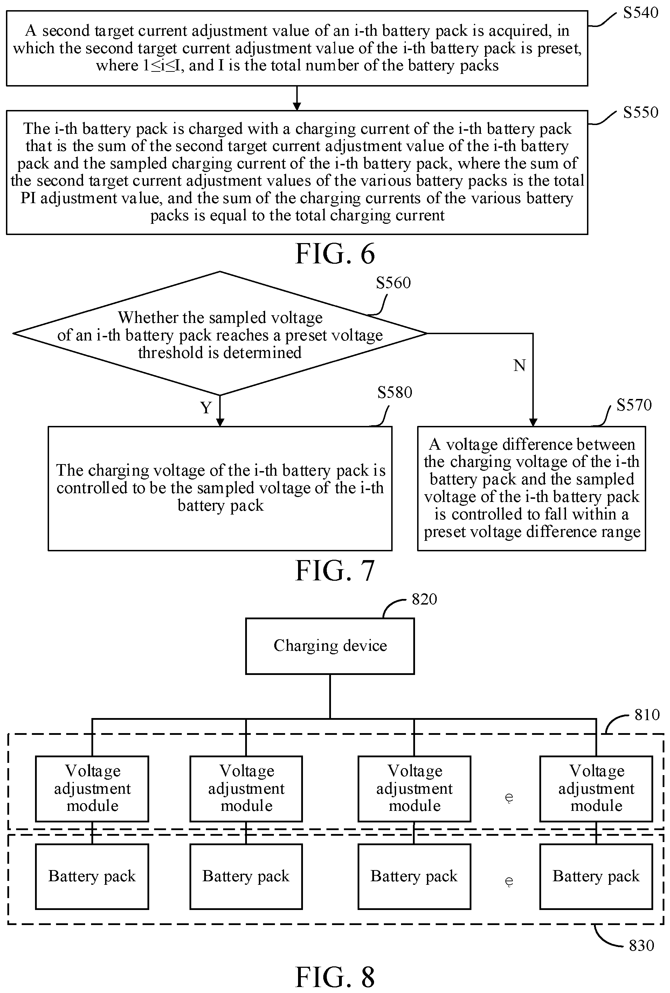

Exemplarily, as shown in Fig. 6, Steps S510-S530 can be replaced by Steps S540 and S550 below.

S540: A second target current adjustment value of an i-th battery pack is acquired, in which the second target current adjustment value of the i-th battery pack is preset, where $1 \leq i \leq I$, and I is the total number of the battery packs.

Each PI adjustment of each battery pack has a fixed value. For example, each charging current adjustment of the battery pack is preset to 0.5A, and 0.5A is the second target current adjustment value corresponding to the battery pack. When the charging current of the battery pack reaches the target charging current, the second target current adjustment value of the battery pack is 0A.

S550: The i-th battery pack is charged with a charging current of the i-th battery pack that is the sum of the second target current adjustment value of the i-th battery pack and the sampled charging current of the i-th battery pack, where the sum of the second target current adjustment values of the various battery packs is the total PI adjustment value, and the sum of the charging currents of the various battery packs is equal to the total charging current.

It can be understood that the PI adjustment of the charging current of each battery pack is carried out by using the second target current adjustment value of each battery pack, to ensure that the sampled charging current of the battery pack can approach the corresponding target charging current quickly and stably. This enables each battery pack to obtain the corresponding target charging current to charge itself, thereby realizing efficient and safe charging of each battery pack. It is to be noted that if the total PI adjustment value is 0, the charging current from the charging device is not adjusted, and the corresponding adjustment will be made according to the sampled current of each battery pack, that is, the adjustment will be made according to Steps S540 and S550. Each battery pack is adjusted according to the preset PI adjustment value. For example, the battery pack A has a sampled charging current of 9A and a target charging current of 10A, and the battery pack B has a sampled charging current of 11A and a target charging current of 10A. In this embodiment, the PI adjustment values of the battery pack A and the battery pack B can both be set to 0.5A. When the charging device outputs a charging current of 20A, the charging current of the battery pack A becomes 9.5A, and the charging current of the battery pack B becomes 10.5A. Because the process of PI adjustment is fast and stable, the charging current of each battery pack can be quickly adjusted to the corresponding target charging current to ensure the charging safety.

Exemplarily, as shown in Fig. 7, the step of determining a charging voltage of each battery pack according to the sampled voltage of each battery pack in Step S500 includes Steps S560-S580.

S560: Whether the sampled voltage of an i-th battery pack reaches a preset voltage threshold is determined, where $1 \leq i \leq I$, and I is the total number of the battery packs. When the sampled voltage of the i-th battery pack does not reach the voltage threshold, Step S570 is performed; and when the sampled voltage of the i-th battery pack reaches the voltage threshold, Step S580 is performed.

S570: a voltage difference between the charging voltage of the i-th battery pack and the sampled voltage of the i-th battery pack is controlled to fall within a preset voltage difference range.

S580: The charging voltage of the i-th battery pack is controlled to be the sampled voltage of the i-th battery pack.

It can be understood that if the sampled voltage of the i-th battery pack does not reach the preset voltage threshold, it means that the i-th battery pack is not fully charged. Then a voltage difference between the charging voltage of the i-th battery pack and the sampled voltage of the i-th battery pack can be controlled to fall within a preset voltage difference range. For example, the range of the preset voltage adjustment value can be 0.8V to 1.2V. That is, there is a voltage difference between the charging voltage input by the charging device to the i-th battery pack and the sampled voltage of the i-th battery pack, so as to ensure that the i-th battery pack is charged at a stabilized voltage. If the sampled voltage of the i-th battery pack reaches the preset voltage threshold, it means that the i-th battery pack is fully charged. To avoid the explosion accident caused by over-voltage of the i-th battery pack, the charging voltage of the i-th battery pack is controlled to be the sampled voltage of the i-th battery pack. That is, the difference between the charging voltage input by the charging device to the i-th battery pack and the sampled voltage of the i-th battery pack is equal to 0, so that the i-th battery pack stops charging.

It can be understood that to control the charging voltages input by the charging device to various battery pack, a voltage adjustment module can be added between each battery pack and the charging device, to control the charging voltage input by the charging device to a corresponding battery pack by the voltage adjustment module connected to each battery pack.

It can be understood that a charging management system for multiple battery packs corresponding to this embodiment is as shown in Fig. 8. The charging management system for multiple battery packs includes voltage adjustment modules 810. The voltage adjustment module 810 is respectively connected to the charging device 820 and the battery pack 830. The voltage adjustment module 810 corresponds one-to-one with the battery pack 830. That is, one voltage adjustment module 810 is connected with one battery pack 830, and each battery pack 830 is connected to one voltage adjustment module 810. The voltage adjustment module 810 controls the charging voltage input by the charging device to the corresponding battery pack 830.

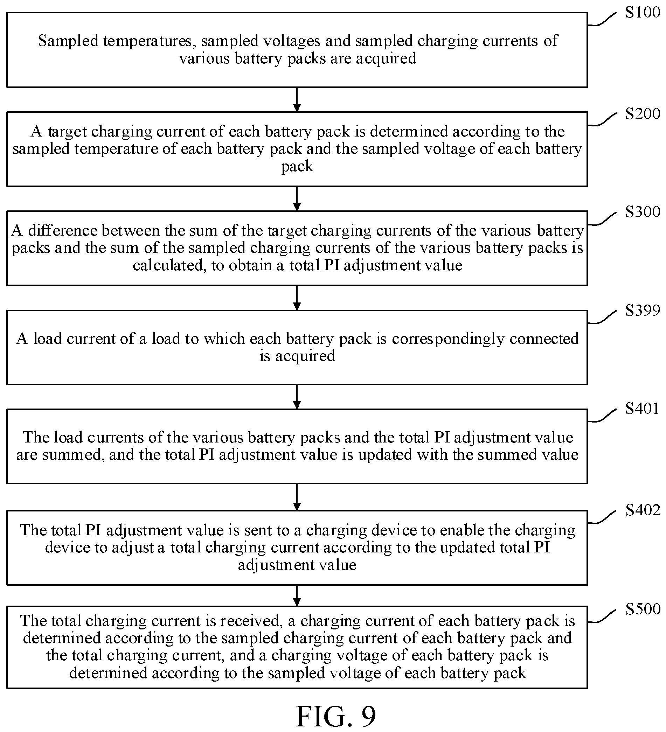

In another embodiment of the present application, as shown in Fig. 9, another charging management method for multiple battery packs is provided. Compared with the above-mentioned embodiments, the charging management method for multiple battery packs provided in this embodiment further includes Step S399 before Step S400, and after Step S399 is added, Step S400 is replaced by Steps S401 and S402. Exemplarily, another charging management method for multiple battery packs includes the following steps:

S100: Sampled temperatures, sampled voltages and sampled charging currents of various battery packs are acquired.

S200: A target charging current of each battery pack is determined according to the sampled temperature of each battery pack and the sampled voltage of each battery pack.

S300: A difference between the sum of the target charging currents of the various battery packs and the sum of the sampled charging currents of the various battery packs is calculated, to obtain a total PI adjustment value.

S399: A load current of a load to which each battery pack is correspondingly connected is acquired.

S401: The load currents of the various battery packs and the total PI adjustment value are summed, and the total PI adjustment value is updated with the summed value.

S402: The updated total PI adjustment value is sent to the charging device, to enable the charging device to adjust a total charging current according to the total PI adjustment value.

S500: The total charging current is received, a charging current of each battery pack is determined according to the sampled charging current of each battery pack and the total charging current, and a charging voltage of each battery pack is determined according to the sampled voltage of each battery pack.

According to the working principle of the battery pack, when the battery pack is in a charging state, a load connected to the battery pack can directly obtain electric energy from the charging device through the connected battery pack, and work normally using the electric energy provided by the charging device. According to the above principle, when multiple battery packs are charged in this embodiment, if some battery packs in the multiple battery packs are connected with loads, a load current of a load to which each battery pack is correspondingly connected is acquired. The load currents of the various battery packs and the total PI adjustment value are summed, and the total PI adjustment value is updated with the summed value. The updated total PI adjustment value is sent to the charging device, to enable the charging device to adjust a total charging current according to the updated total PI adjustment value. In this embodiment, when efficient and safe charging of multiple battery packs are realized, the normal work of the load connected to the battery pack is ensured, and the load working normally does not affect the charging process of the multiple battery packs, so that the efficient and safe charging can still be maintained when the battery pack is connected with a load. It is to be noted that the load currents of the various battery packs and the total PI adjustment value are summed, the total PI adjustment value is updated with the summed value, and the total PI adjustment value of updated values is sent to the charging device. After the charging device adjusts the input charging current according to the total PI adjustment value of updated values, the charging current will be divided into two parts, one part will directly power the load, and the other part will charge the battery pack. Particularly, the total PI adjustment value before value updation is called the first total PI adjustment value, and the total PI adjustment value of updated value is called the second total PI adjustment value, which are used to further explain this embodiment. If a battery pack A and a battery pack B are charged at the same time, the target currents of the battery pack A and the battery pack B are 10A respectively, then the total target current is 20A; and the sampled charging currents of the battery pack A and the battery pack B are respectively 9A, then the total sampled charging current is 18A. If the first total PI adjustment value is determined to be 1A, and the battery pack A is connected to a load having a current demand (called load current in the present application of 5A at this time, then the second total PI adjustment value = first total PI adjustment value + 5A, that is, the total PI adjustment value is 6A. After the second total PI adjustment value of 6A is sent to the charging device, the charging current output by the charging device is 24A. In the charging current of 24A, a current of 5A will be used to directly power the load, and the remaining current of 19A will charge the battery pack A and the battery pack B respectively according to the distribution method in other embodiments mentioned above. In specific embodiments, directly powering the load with a part of the charging current output by the charging device is implemented as follows. When the battery pack A is connected to a load and not being charged, the battery pack A outputs a current to power the load. When the battery pack A is connected to a load and being charged, an input interface of the battery pack A receives the charging current, a part of the charging current will flow directly to the load and the other part will flow to the battery pack A.

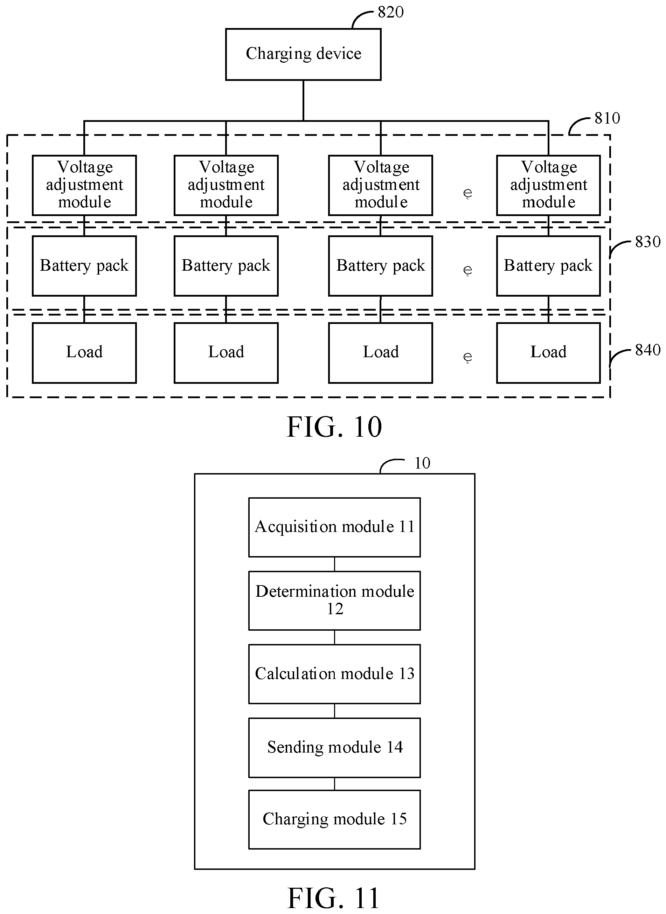

It can be understood that a charging management system for multiple battery packs corresponding to this embodiment is as shown in Fig. 10. The charging management system for multiple battery packs includes voltage adjustment modules 810. The voltage adjustment module 810 is respectively connected to the charging device 820 and the battery pack 830. The voltage adjustment module 810 corresponds one-to-one with the battery pack 830. That is, one voltage adjustment module 810 is connected with one battery pack 830, and each battery pack 830 is connected to one voltage adjustment module 810. The voltage adjustment module 810 controls the charging voltage input by the charging device to the corresponding battery pack 830. The battery pack 830 is connected with at least one load 840.

In another embodiment of the present invention, a charging management apparatus for multiple battery packs is provided. As shown in Fig. 11, the charging management apparatus 10 for multiple battery packs includes: an acquisition module 11 a determination module 12, a calculation module13, a sending module 14 and charging module 15.

The acquisition module 11 is configured to acquire sampled temperatures, sampled voltages and sampled charging currents of various battery packs. The determination module 12 is configured to determine a target charging current of each battery pack according to the sampled temperature of each battery pack and the sampled voltage of each battery pack. The calculation module 13 is configured to calculate a total PI adjustment value according to the target charging currents and the sampled charging currents of the various battery packs. The sending module 14 is configured to send the total PI adjustment value to a charging device, to enable the charging device to adjust a total charging current according to the total PI adjustment value. The charging module 15 is configured to receive the total charging current, determine a charging current of each battery pack according to the sampled charging current of each battery pack and the total charging current, and determine a charging voltage of each battery pack according to the sampled voltage of each battery pack.

In other embodiments, the charging management apparatus for multiple battery packs further includes voltage adjustment modules, configured to control the charging voltage input to the battery pack. The voltage adjustment module corresponds one-to-one with the battery pack.

In the charging management apparatus 10 for multiple battery packs disclosed in this embodiment, the acquisition module 11, the determination module 12, the calculation module13, the sending module 14 and the charging module 15 are used in combination, to implement the charging management method for multiple battery packs according to the embodiments above. The implementations and beneficial effects involved in the above-mentioned embodiments are equally applicable in this embodiment, and will not be repeated here.

It can be understood that the present application relates to an energy storage device, which includes a storage and a processor, where the storage stores a computer program thereon, and the computer program, when executed by the processor, implements the charging management method for multiple battery packs according to the present application.

It can be understood that the present application relates to a readable storage medium, not separately claimed in the present application and storing a computer program, where the computer program, when executed by a processor, implements the charging management method for multiple battery packs according to the present application.

In the embodiments provided in the present application, it can be understood that the disclosed apparatus and method may be implemented in other ways. The apparatus embodiments described above are merely illustrative. For example, the flowcharts and structural diagrams in the accompanying drawings illustrate the architecture, functionality, and operation of possible implementations of devices, methods and computer program products according to various embodiments of the present application. In this regard, each box in a flowchart or a block diagram may represent a module, a program segment, or a part of code. The module, the program segment, or the part of code includes one or more executable instructions used for implementing designated logic functions. It should also be noted that in some alternative implementations, functions annotated in boxes may occur in a sequence different from that annotated in the accompanying drawing. For example, actually two boxes shown in succession can be performed basically in parallel, and sometimes the two boxes can be performed in a reverse sequence. This depends on the related functions. It should also be noted that each box in a block diagram and/or a flowchart and a combination of boxes in the block diagram and/or the flowchart may be implemented by using a dedicated hardware-based system configured to perform a specified function or operation, or may be implemented by using a combination of dedicated hardware and a computer instruction.

In addition, the functional modules or units in the various embodiments of the present application may be integrated into a separate part, or each of the modules may be present separately, or two or more modules may be integrated into separate part.

The functions, if implemented in the form of a software program module and sold or used as a stand-alone product, may be stored in a computer readable storage medium. Based on such an understanding, the essence of the technical solution of present application or part thereof contributing to the related art, or part of the technical solution can be implemented by a software product. The computer software product is stored in a storage medium and includes several instructions for instructing a computer device (which may be a smart phone, a personal computer, a server, a network device, or the like) to perform all or some of the steps of the methods described in the embodiments of the present application. The foregoing storage medium includes a USB disk, a movable hard disk, a Read Only Memory (ROM), a Random Access Memory (RAM), a magnetic disk, an optical disc and other media that can store program codes.

The foregoing descriptions are merely specific implementations of the present application, but are not intended to limit the scope of protection of the present application.

**Claims**

1. A charging management method for multiple battery packs (830), comprising:

    acquiring sampled temperatures, sampled voltages and sampled charging currents of various battery packs;
    determining a target charging current of each battery pack (830) according to the sampled temperature of the respective battery pack (830) and the sampled voltage of the respective battery pack (830);
    calculating a difference between a sum of the target charging currents of the various battery packs and a sum of the sampled charging currents of the various battery packs, to obtain a total PI adjustment value;
    sending the total PI adjustment value to a charging device (820), to enable the charging device (820) to adjust a total charging current according to the total PI adjustment value; and
    receiving the total charging current, determining a charging current of each battery pack (830) according to the sampled charging current of the respective battery pack (830) and the total charging current, and determining a charging voltage of each battery pack (830) according to the sampled voltage of the respective battery pack (830).

2. The charging management method for multiple battery packs (830) according to claim 1, wherein the step of acquiring sampled temperatures of the various battery packs comprises:

acquiring battery core temperatures at a predetermined number of preset locations in an i-th battery pack, where $1 \leq i \leq I$, and I is the total number of the battery packs (830);
calculating a mean of the battery core temperatures at the predetermined number of preset locations; and
taking the mean as the sampled temperature of the i-th battery pack.

3. The charging management method for multiple battery packs (830) according to claim 1, wherein the step of determining a target charging current of each battery pack (830) according to the sampled temperature and the sampled voltage of the respective battery pack (830) comprises:

determining a first charging current corresponding to the sampled temperature of an i-th battery pack according to a look-up table of the battery pack temperature and the target charging current, where $1 \leq i \leq I$, and I is the total number of the battery packs (830);
determining a second charging current corresponding to the sampled voltage of the i-th battery pack according to a look-up table of the battery pack voltage and the target charging current; and
taking a lower one of the first charging current and the second charging current as the target charging current of the i-th battery pack.

4. The charging management method for multiple battery packs (830) according to claim 1, wherein the step of determining a charging current of each battery pack (830) according to the sampled charging current of the respective battery pack (830) and the total charging current comprises:

calculating a difference between the target charging current of an i-th battery pack and the sampled charging current of the i-th battery pack to determine a current difference of the i-th battery pack, where $1 \leq i \leq I$, and I is the total number of the battery packs (830);
determining a first target current adjustment value of the i-th battery pack according to the current differences of the various battery packs and the total PI adjustment value; and
charging the i-th battery pack with a charging current of the i-th battery pack that is the sum of the first target current adjustment value of the i-th battery pack and the sampled charging current of the i-th battery pack, where the sum of the charging currents of the various battery packs is equal to the total charging current.

5. The charging management method for multiple battery packs (830) according to claim 1, wherein the step of determining a charging current of each battery pack (830) according to the sampled charging current of the respective battery pack (830) and the total charging current comprises:

acquiring a second target current adjustment value of an i-th battery pack, in which the second target current adjustment value of the i-th battery pack is preset, where $1 \leq i \leq I$, and I is the total number of the battery packs (830);
charging the i-th battery pack with a charging current of the i-th battery pack that is the sum of the second target current adjustment value of the i-th battery pack and the sampled charging current of the i-th battery pack, where the sum of the second target current adjustment values of the various battery packs is the total PI adjustment value, and the sum of the charging currents of the various battery packs is equal to the total charging current.

6. The charging management method for multiple battery packs (830) according to claim 1, wherein the step of determining a charging voltage of each battery pack (830) according to the sampled voltage of the respective battery pack (830) comprises:

determining whether the sampled voltage of an i-th battery pack reaches a preset voltage threshold, where $1 \leq i \leq I$, and I is the total number of the battery packs (830);
when the sampled voltage of the i-th battery pack does not reach the voltage threshold, controlling a voltage difference between the charging voltage of the i-th battery pack and the sampled voltage of the i-th battery pack to fall within a preset voltage difference range; and
when the sampled voltage of the i-th battery pack reaches the voltage threshold, controlling the charging voltage of the i-th battery pack to be the sampled voltage of the i-th battery pack.

7. The charging management method for multiple battery packs (830) according to claim 1, further comprising, before the step of sending the total PI adjustment value to the charging device (820),

acquiring a load current of a load (840) to which each battery pack (830) is correspondingly connected, wherein the step of sending the total PI adjustment value to the charging device (820) comprises:

summing the load currents of the various battery packs and the total PI adjustment value, and updating the total PI adjustment value with the summed value; and
sending the updated total PI adjustment value to the charging device (820).

8. A charging management apparatus (10) for multiple battery packs (830), comprising:

an acquisition module (11), configured to acquire sampled temperatures, sampled voltages and sampled charging currents of various battery packs;
a determination module (12), configured to determine a target charging current of each battery pack (830) according to the sampled temperature of the respective battery pack (830) and the sampled voltage of the respective battery pack (830);
a calculation module (13), configured to calculate a difference between a sum of the target charging currents of the various battery packs and a the sum of the sampled charging currents of the various battery packs, to obtain a total PI adjustment value;
a sending module (14), configured to send the total PI adjustment value to a charging device (820), to enable the charging device (820) to adjust a total charging current according to the total PI adjustment value; and
a charging module (15), configured to receive the total charging current, determine a charging current of each battery pack (830) according to the sampled charging current of the respective battery pack (830) and the total charging current, and determine a charging voltage of each battery pack (830) according to the sampled voltage of the respective battery pack (830).

9. The charging management apparatus (10) for multiple battery packs (830) according to claim 8, further comprising:
a voltage adjustment module (810), configured to control the charging voltage input to a battery pack (830).

10. The charging management apparatus (10) for multiple battery packs (830) according to claim 9, wherein the voltage adjustment module corresponds one-to-one with the battery pack (830).

11. An energy storage device, comprising a storage and a processor, wherein the storage stores a computer program thereon, and the computer program, when executed by the processor, implements the charging management method for multiple battery packs (830) according to any one of claims 1 to 7.

**Patentansprüche**

1. Verfahren zur Verwaltung des Ladens für mehrere Batteriepacks (830), umfassend:

Erfassen von abgetasteten Temperaturen, abgetasteten Spannungen und abgetasteten Ladeströmen von verschiedenen Batteriepacks;
Bestimmen eines Soll-Ladestroms für jedes Batteriepack (830) gemäß der abgetasteten Temperatur des jeweiligen Batteriepacks (830) und der abgetasteten Spannung des jeweiligen Batteriepacks (830);
Berechnen einer Differenz zwischen einer Summe der Soll-Ladeströme der verschiedenen Batteriepacks und einer Summe der abgetasteten Ladeströme der verschiedenen Batteriepacks, um einen PI-Gesamteinstellwert zu erhalten;
Senden des PI-Gesamteinstellwerts an eine Ladevorrichtung (820), um der Ladevorrichtung (820) zu ermöglichen, einen Gesamtladestrom gemäß dem PI-Gesamteinstellwert einzustellen; und
Empfangen des Gesamtladestroms, Bestimmen eines Ladestroms für jedes Batteriepack (830) gemäß dem abgetasteten Ladestrom des jeweiligen Batteriepacks (830) und dem Gesamtladestrom, und Bestimmen einer Ladespannung für jedes Batteriepack (830) gemäß der abgetasteten Spannung des jeweiligen Batteriepacks (830).

2. Verfahren zur Verwaltung des Ladens für mehrere Batteriepacks (830) nach Anspruch 1, wobei der Schritt des Erfassens von abgetasteten Temperaturen der verschiedenen Batteriepacks Folgendes umfasst:

Erfassen von Batteriekerntemperaturen an einer vorbestimmten Anzahl von voreingestellten Positionen in einem i-ten Batteriepack, wobei $1 \leq i \leq I$ und I die Gesamtzahl des Batteriepacks (830) ist;

Berechnen eines Mittelwerts der Batteriekerntemperaturen an der vorbestimmten Anzahl von voreingestellten Positionen; und Verwenden des Mittelwerts als die abgetastete Temperatur des i-ten Batteriepacks.

3. Verfahren zur Verwaltung des Ladens für mehrere Batteriepacks (830) nach Anspruch 1, wobei der Schritt des Bestimmens eines Soll-Ladestroms für jedes Batteriepack (830) gemäß der abgetasteten Temperatur und der abgetasteten Spannung des jeweiligen Batteriepacks (830) Folgendes umfasst:

Bestimmen eines ersten Ladestroms, der der abgetasteten Temperatur eines i-ten Batteriepacks entspricht, gemäß einer Nachschlagetabelle der Batteriepacktemperatur und des Soll-Ladestroms, wobei $1 \leq i \leq I$ und I die Gesamtzahl des Batteriepacks (830) ist;
Bestimmen eines zweiten Ladestroms, der der abgetasteten Spannung des i-ten Batteriepacks entspricht, gemäß einer Nachschlagetabelle für die Batteriepackspannung und den Soll-Ladestrom; und
Verwenden eines niedrigeren des ersten und des zweiten Ladestroms als Soll-Ladestrom des i-ten Batteriepacks.

4. Verfahren zur Verwaltung des Ladens für mehrere Batteriepacks (830) nach Anspruch 1, wobei der Schritt des Bestimmens eines Ladestroms für jedes Batteriepack (830) gemäß dem abgetasteten Ladestrom des jeweiligen Batteriepacks (830) und dem Gesamtladestrom Folgendes umfasst:

Berechnen einer Differenz zwischen dem Soll-Ladestrom eines i-ten Batteriepacks und dem abgetasteten Ladestrom des i-ten Batteriepacks, um eine Stromdifferenz des i-ten Batteriepacks zu bestimmen, wobei $1 \leq i \leq I$ und I die Gesamtzahl des Batteriepacks (830) ist;
Bestimmen eines ersten Soll-Stromeinstellwerts des i-ten Batteriepacks gemäß den Stromdifferenzen der verschiedenen Batteriepacks und dem PI-Gesamteinstellwert; und
Laden des i-ten Batteriepacks mit einem Ladestrom des i-ten Batteriepacks, der die Summe aus dem ersten Soll-Stromeinstellwert des i-ten Batteriepacks und dem abgetasteten Ladestrom des i-ten Batteriepacks ist, wobei die Summe der Ladeströme der verschiedenen Batteriepacks gleich dem Gesamtladestrom ist.

5. Verfahren zur Verwaltung des Ladens für mehrere Batteriepacks (830) nach Anspruch 1, wobei der Schritt des Bestimmens eines Ladestroms für jedes Batteriepack (830) gemäß dem abgetasteten Ladestrom des jeweiligen Batteriepacks (830) und dem Gesamtladestrom Folgendes umfasst:

Erfassen eines zweiten Soll-Stromeinstellwerts eines i-ten Batteriepacks, wobei der zweite Soll-Stromeinstellwert des i-ten Batteriepacks voreingestellt ist, wobei $1 \leq i \leq I$ und I die Gesamtzahl des Batteriepacks (830) ist;
Laden des i-ten Batteriepacks mit einem Ladestrom des i-ten Batteriepacks, der die Summe des zweiten Soll-Stromeinstellwerts des i-ten Batteriepacks und des abgetasteten Ladestroms des i-ten Batteriepacks ist, wobei die Summe der zweiten Soll-Stromeinstellwerte der verschiedenen Batteriepacks der PI-Gesamteinstellwert ist und die Summe der Ladeströme der verschiedenen Batteriepacks gleich dem Gesamtladestrom ist.

6. Verfahren zur Verwaltung des Ladens für mehrere Batteriepacks (830) nach Anspruch 1, wobei der Schritt des Bestimmens einer Ladespannung für jedes Batteriepack (830) gemäß der abgetasteten Spannung des jeweiligen Batteriepacks (830) Folgendes umfasst:

Bestimmen, ob die abgetastete Spannung eines i-ten Batteriepacks eine voreingestellte Spannungsschwelle erreicht, wobei $1 \leq i \leq I$ und I die Gesamtzahl des Batteriepacks (830) ist;
wenn die abgetastete Spannung des i-ten Batteriepacks die Spannungsschwelle nicht erreicht, Steuern einer Spannungsdifferenz zwischen der Ladespannung des i-ten Batteriepacks und der abgetasteten Spannung des i-ten Batteriepacks, so dass sie innerhalb eines voreingestellten Spannungsdifferenzbereichs fällt; und
wenn die abgetastete Spannung des i-ten Batteriepacks die Spannungsschwelle erreicht, Steuern der Ladespannung des i-ten Batteriepacks, so dass sie der abgetasteten Spannung des i-ten Batteriepacks entspricht.

7. Verfahren zur Verwaltung des Ladens für mehrere Batteriepacks (830) nach Anspruch 1, ferner umfassend, vor dem Schritt des Sendens des PI-Gesamteinstellwerts an die Ladevorrichtung (820),

Erfassen eines Laststroms einer Last (840), an die jedes Batteriepack (830) entsprechend angeschlossen ist, wobei der Schritt des Sendens des PI-Gesamteinstellwerts an die Ladevorrichtung (820) Folgendes umfasst:

Summieren der Lastströme der verschiedenen Batteriepacks und des PI-Gesamteinstellwerts und Aktualisieren des PI-Gesamteinstellwerts mit dem summierten Wert; und
Senden des aktualisierten PI-Gesamteinstellwerts an die Ladevorrichtung (820).

8. Gerät zur Verwaltung des Ladens (10) für mehrere Batteriepacks (830), umfassend: ein Erfassungsmodul (11), das so konfiguriert ist, dass es abgetastete Temperaturen, abgetastete Spannungen und abgetastete Ladeströme von verschiedenen Batteriepacks erfasst;

ein Bestimmungsmodul (12), das so konfiguriert ist, dass es einen Soll-Ladestrom für jedes Batteriepack (830) gemäß der abgetasteten Temperatur des jeweiligen Batteriepacks (830) und der abgetasteten Spannung des jeweiligen Batteriepacks (830) bestimmt;
ein Berechnungsmodul (13), das so konfiguriert ist, dass es eine Differenz zwischen einer Summe der Soll-Ladeströme der verschiedenen Batteriepacks und einer Summe der abgetasteten Ladeströme der verschiedenen Batteriepacks berechnet, um einen PI-Gesamteinstellwert zu erhalten;
ein Sendemodul (14), das so konfiguriert ist, dass es den PI-Gesamteinstellwert an eine Ladevorrichtung (820) sendet, um der Ladevorrichtung (820) zu ermöglichen, einen Gesamtladestrom gemäß dem PI-Gesamteinstellwert einzustellen; und
ein Lademodul (15), das so konfiguriert ist, dass es den Gesamtladestrom empfängt, einen Ladestrom für jedes Batteriepack (830) gemäß dem abgetasteten Ladestrom des jeweiligen Batteriepacks (830) und dem Gesamtladestrom bestimmt und eine Ladespannung für jedes Batteriepack (830) gemäß der abgetasteten Spannung des jeweiligen Batteriepacks (830) bestimmt.

9. Gerät zur Verwaltung des Ladens (10) für mehrere Batteriepacks (830) nach Anspruch 8, ferner umfassend:
ein Spannungseinstellmodul (810), das so konfiguriert ist, dass es die Ladespannung steuert, die in das Batteriepack (830) eingegeben wird.

10. Gerät zur Verwaltung des Ladens (10) für mehrere Batteriepacks (830) nach Anspruch 9, wobei das Spannungseinstellmodul eins zu eins dem Batteriepack (830) entspricht.

11. Energiespeichervorrichtung, umfassend einen Speicher und einen Prozessor, wobei der Speicher ein Computerprogramm speichert und das Computerprogramm, wenn es von dem Prozessor ausgeführt wird, das Verfahren zur Verwaltung des Ladens für mehrere Batteriepacks (830) nach einem der Ansprüche 1 bis 7 implementiert.

**Revendications**

1. Procédé de gestion de charge pour une pluralité de blocs-batteries (830), comprenant :

l'acquisition de températures échantillonnées, de tensions échantillonnées et de courants de charge échantillonnés de divers blocs-batteries ;
la détermination d'un courant de charge cible de chaque bloc-batterie (830) selon la température échantillonnée du bloc-batterie (830) respectif et la tension échantillonnée du bloc-batterie (830) respectif ;
le calcul d'une différence entre une somme des courants de charge cibles des divers blocs-batteries et une somme des courants de charge échantillonnés des divers blocs-batteries, afin d'obtenir une valeur d'ajustement PI totale ;
l'envoi de la valeur d'ajustement PI totale à un dispositif de charge (820), afin de permettre au dispositif de charge (820) d'ajuster un courant de charge total selon la valeur d'ajustement PI totale ; et
la réception du courant de charge total, la détermination d'un courant de charge de chaque bloc-batterie (830) selon le courant de charge échantillonné du bloc-batterie (830) respectif et le courant de charge total, et la détermination d'une tension de charge de chaque bloc-batterie (830) selon la tension échantillonnée du bloc-batterie (830) respectif.

2. Procédé de gestion de charge pour une pluralité de blocs-batteries (830) selon la revendication 1, dans lequel l'étape d'acquisition des températures échantillonnées des divers blocs-batteries comprend :

l'acquisition des températures du noyau de batterie à un nombre prédéterminé d'emplacements prédéfinis dans un $i$-ème bloc-batterie, où $1 \leq i \leq I$, et I est le nombre total des blocs-batteries (830) ;
le calcul d'une moyenne des températures du noyau de batterie auxdits emplacements prédéfinis ; et
la prise de la moyenne comme température échantillonnée du $i$-ème bloc-batterie.

3. Procédé de gestion de charge pour une pluralité de blocs-batteries (830) selon la revendication 1, dans lequel l'étape de détermination d'un courant de charge cible de chaque bloc-batterie (830) selon la température échantillonnée et la tension échantillonnée du bloc-batterie (830) respectif comprend :

la détermination d'un premier courant de charge correspondant à la température échantillonnée d'un $i$-ème bloc-batterie selon une table de correspondance de la température du bloc-batterie et du courant de charge cible, où $1 \leq i \leq I$, et $I$ est le nombre total des blocs-batteries (830) ;
la détermination d'un second courant de charge correspondant à la tension échantillonnée du $i$-ème bloc-batterie selon une table de correspondance de la tension du bloc-batterie et du courant de charge cible ; et
la prise de la valeur la plus faible entre le premier courant de charge et le second courant de charge comme courant de charge cible du $i$-ème bloc-batterie.

4. Procédé de gestion de charge pour une pluralité de blocs-batteries (830) selon la revendication 1, dans lequel l'étape de détermination d'un courant de charge de chaque bloc-batterie (830) selon le courant de charge échantillonné du bloc-batterie (830) respectif et le courant de charge total comprend :

le calcul d'une différence entre le courant de charge cible d'un $i$-ème bloc-batterie et le courant de charge échantillonné du $i$-ème bloc-batterie afin de déterminer une différence de courant du $i$-ème bloc-batterie, où $1 \leq i \leq I$, et $I$ est le nombre total des blocs-batteries (830) ;
la détermination d'une première valeur d'ajustement de courant cible du $i$-ème bloc-batterie selon les différences de courant des divers blocs-batteries et la valeur d'ajustement PI totale ; et
la charge du $i$-ème bloc-batterie avec un courant de charge du $i$-ème bloc-batterie qui est la somme de la première valeur d'ajustement de courant cible du $i$-ème bloc-batterie et du courant de charge échantillonné du $i$-ème bloc-batterie, la somme des courants de charge des divers blocs-batteries étant égale au courant de charge total.

5. Procédé de gestion de charge pour une pluralité de blocs-batteries (830) selon la revendication 1, dans lequel l'étape de détermination d'un courant de charge de chaque bloc-batterie (830) selon le courant de charge échantillonné du bloc-batterie (830) respectif et le courant de charge total comprend :

l'acquisition d'une seconde valeur d'ajustement de courant cible d'un $i$-ème bloc-batterie, dans laquelle la seconde valeur d'ajustement de courant cible du $i$-ème bloc-batterie est prédéfinie, où $1 \leq i \leq I$, et $I$ est le nombre total des blocs-batteries (830) ;
la charge du $i$-ème bloc-batterie avec un courant de charge du $i$-ème bloc-batterie qui est la somme de la seconde valeur d'ajustement de courant cible du $i$-ème bloc-batterie et du courant de charge échantillonné du $i$-ème bloc-batterie, la somme des secondes valeurs d'ajustement de courant cible des divers blocs-batteries étant la valeur d'ajustement PI totale, et la somme des courants de charge des divers blocs-batteries étant égale au courant de charge total.

6. Procédé de gestion de charge pour une pluralité de blocs-batteries (830) selon la revendication 1, dans lequel l'étape de détermination d'une tension de charge de chaque bloc-batterie (830) selon la tension échantillonnée du bloc-batterie (830) respectif comprend :

la détermination de savoir si la tension échantillonnée d'un $i$-ème bloc-batterie atteint un seuil de tension prédéfini, où $1 \leq i \leq I$, et $I$ est le nombre total des blocs-batteries (830) ;
lorsque la tension échantillonnée du $i$-ème bloc-batterie n'atteint pas le seuil de tension, le contrôle d'une différence de tension entre la tension de charge du $i$-ème bloc-batterie et la tension échantillonnée du $i$-ème bloc-batterie de sorte qu'elle soit comprise dans une plage de différence de tension prédéfinie ; et
lorsque la tension échantillonnée du $i$-ème bloc-batterie atteint le seuil de tension, le contrôle de la tension de charge du $i$-ème bloc-batterie de sorte qu'elle soit égale à la tension échantillonnée du $i$-ème bloc-batterie.

7. Procédé de gestion de charge pour une pluralité de blocs-batteries (830) selon la revendication 1, comprenant en outre, avant l'étape d'envoi de la valeur d'ajustement PI totale au dispositif de charge (820),

l'acquisition d'un courant de charge d'une charge (840) à laquelle chaque bloc-batterie (830) est connecté de manière correspondante,
dans lequel l'étape d'envoi de la valeur d'ajustement PI totale au dispositif de charge (820) comprend :

la sommation des courants de charge des diverses charges et de la valeur d'ajustement PI totale, et la mise à jour de la valeur d'ajustement PI totale avec la valeur sommée ; et

l'envoi de la valeur d'ajustement PI totale mise à jour au dispositif de charge (820).

8. Appareil de gestion de charge (10) pour une pluralité de blocs-batteries (830), comprenant :

un module d'acquisition (11), configuré pour acquérir des températures échantillonnées, des tensions échantillonnées et des courants de charge échantillonnés de divers blocs-batteries ;
un module de détermination (12), configuré pour déterminer un courant de charge cible de chaque bloc-batterie (830) selon la température échantillonnée du bloc-batterie (830) respectif et la tension échantillonnée du bloc-batterie (830) respectif ;
un module de calcul (13), configuré pour calculer une différence entre une somme des courants de charge cibles des divers blocs-batteries et une somme des courants de charge échantillonnés des divers blocs-batteries, afin d'obtenir une valeur d'ajustement PI totale ;
un module d'envoi (14), configuré pour envoyer la valeur d'ajustement PI totale à un dispositif de charge (820), afin de permettre au dispositif de charge (820) d'ajuster un courant de charge total selon la valeur d'ajustement PI totale ; et
un module de charge (15), configuré pour recevoir le courant de charge total, déterminer un courant de charge de chaque bloc-batterie (830) selon le courant de charge échantillonné du bloc-batterie (830) respectif et le courant de charge total, et déterminer une tension de charge de chaque bloc-batterie (830) selon la tension échantillonnée du bloc-batterie (830) respectif.

9. Appareil de gestion de charge (10) pour une pluralité de blocs-batteries (830) selon la revendication 8, comprenant en outre :
un module d'ajustement de tension (810), configuré pour contrôler la tension de charge appliquée à un bloc-batterie (830).

10. Appareil de gestion de charge (10) pour une pluralité de blocs-batteries (830) selon la revendication 9, dans lequel le module d'ajustement de tension correspond un-à-un au bloc-batterie (830).

11. Dispositif de stockage d'énergie, comprenant une mémoire et un processeur, la mémoire stockant un programme informatique, et le programme informatique, lorsqu'il est exécuté par le processeur, met en oeuvre le procédé de gestion de charge pour une pluralité de blocs-batteries (830) selon l'une quelconque des revendications 1 à 7.

| |
|---|
| Sampled temperatures, sampled voltages and sampled charging currents of various battery packs are acquired |

S100

| |
|---|
| A target charging current of each battery pack is determined according to the sampled temperature of each battery pack and the sampled voltage of each battery pack |

S200

| |
|---|
| A difference between the sum of the target charging currents of the various battery packs and the sum of the sampled charging currents of the various battery packs is calculated, to obtain a total PI adjustment value |

S300

| |
|---|
| The total PI adjustment value is sent to a charging device to enable the charging device to adjust a total charging current according to the total PI adjustment value |

S400

| |
|---|
| The total charging current is received, a charging current of each battery pack is determined according to the sampled charging current of each battery pack and the total charging current, and a charging voltage of each battery pack is determined according to the sampled voltage of each battery pack |

S500

## FIG. 1

| |
|---|
| Battery core temperatures at a predetermined number of preset locations in an i-th battery pack are acquired, where $1 \leq i \leq I$, and I is the total number of the battery packs |

S110

| |
|---|
| A mean of the battery core temperatures at the predetermined number of preset locations is calculated |

S120

| |
|---|
| The mean is taken as the sampled temperature of the i-th battery pack |

S130

## FIG. 2

A first charging current corresponding to the sampled temperature of an i-th battery pack is determined according to a look-up table of the battery pack temperature and the target charging current, where 1≤i≤I, and I is the total number of the battery packs — S210

A second charging current corresponding to the sampled voltage of the i-th battery pack is determined according to a look-up table of the battery pack voltage and the target charging current — S220

A lower one of the first charging current and the second charging current is taken as the target charging current of the i-th battery pack — S230

## FIG. 3

Sum of target charging currents → ⊗ → Total PI adjustment value → Total PI adjustment module → Total charging current

Sum of sampled charging currents

## FIG. 4

A difference between the target charging current of an i-th battery pack and the sampled charging current of the i-th battery pack is calculated to determine a current difference of the i-th battery pack, where 1≤i≤I, and I is the total number of the battery packs — S510

A first target current adjustment value of the i-th battery pack is determined according to the current differences of the various battery packs and the total PI adjustment value — S520

The i-th battery pack is charged with a charging current of the i-th battery pack that is the sum of the first target current adjustment value of the i-th battery pack and the sampled charging current of the i-th battery pack, where the sum of the charging currents of the various battery packs is equal to the total charging current — S530

## FIG. 5

S540

A second target current adjustment value of an i-th battery pack is acquired, in which the second target current adjustment value of the i-th battery pack is preset, where $1 \leq i \leq I$, and I is the total number of the battery packs

S550

The i-th battery pack is charged with a charging current of the i-th battery pack that is the sum of the second target current adjustment value of the i-th battery pack and the sampled charging current of the i-th battery pack, where the sum of the second target current adjustment values of the various battery packs is the total PI adjustment value, and the sum of the charging currents of the various battery packs is equal to the total charging current

## FIG. 6

S560

Whether the sampled voltage of an i-th battery pack reaches a preset voltage threshold is determined

N

Y

S580

The charging voltage of the i-th battery pack is controlled to be the sampled voltage of the i-th battery pack

S570

A voltage difference between the charging voltage of the i-th battery pack and the sampled voltage of the i-th battery pack is controlled to fall within a preset voltage difference range

## FIG. 7

820

Charging device

810

| Voltage adjustment module | Voltage adjustment module | Voltage adjustment module | e | Voltage adjustment module |

| Battery pack | Battery pack | Battery pack | e | Battery pack |

830

## FIG. 8

```
┌─────────────────────────────────────────────────────────────────┐        S100
│        Sampled temperatures, sampled voltages and sampled       │   ⟋
│          charging currents of various battery packs are         │
│                            acquired                             │
└─────────────────────────────────────────────────────────────────┘
                                  │
                                  ▼
┌─────────────────────────────────────────────────────────────────┐        S200
│   A target charging current of each battery pack is determined  │   ⟋
│   according to the sampled temperature of each battery pack and │
│         the sampled voltage of each battery pack               │
└─────────────────────────────────────────────────────────────────┘
                                  │
                                  ▼
┌─────────────────────────────────────────────────────────────────┐        S300
│  A difference between the sum of the target charging currents of │   ⟋
│   the various battery packs and the sum of the sampled charging  │
│  currents of the various battery packs is calculated, to obtain  │
│                   a total PI adjustment value                    │
└─────────────────────────────────────────────────────────────────┘
                                  │
                                  ▼
┌─────────────────────────────────────────────────────────────────┐        S399
│  A load current of a load to which each battery pack is          │   ⟋
│         correspondingly connected is acquired                    │
└─────────────────────────────────────────────────────────────────┘
                                  │
                                  ▼
┌─────────────────────────────────────────────────────────────────┐        S401
│  The load currents of the various battery packs and the total PI │   ⟋
│  adjustment value are summed, and the total PI adjustment value  │
│               is updated with the summed value                   │
└─────────────────────────────────────────────────────────────────┘
                                  │
                                  ▼
┌─────────────────────────────────────────────────────────────────┐        S402
│  The total PI adjustment value is sent to a charging device to   │   ⟋
│  enable the charging device to adjust a total charging current   │
│       according to the updated total PI adjustment value         │
└─────────────────────────────────────────────────────────────────┘
                                  │
                                  ▼
┌─────────────────────────────────────────────────────────────────┐        S500
│  The total charging current is received, a charging current of   │   ⟋
│  each battery pack is determined according to the sampled        │
│  charging current of each battery pack and the total charging    │
│  current, and a charging voltage of each battery pack is         │
│  determined according to the sampled voltage of each battery pack│
└─────────────────────────────────────────────────────────────────┘
```

## FIG. 9

FIG. 10

FIG. 11

**EP 4 376 250 B1**

**REFERENCES CITED IN THE DESCRIPTION**

**Patent documents cited in the description**

- CN 113131550 A
- CN 112994156 A